# NEUE EUROPÄISCHE PATENTSCHRIFT

(11) **EP 0 689 374 B2**
(45) Veröffentlichungstag und Bekanntmachung des Hinweises auf die Entscheidung über den Einspruch: **29.07.2009**
(45) Hinweis auf die Patenterteilung: 05.03.2003
(21) Anmeldenummer: 95106186.0
(22) Anmeldetag: 26.04.1995
(51) Int. Cl.: H05K 5/00, B60R 16/02

(54) **Elektronikmodul**
Electronic module
Module électronique

(30) Priorität: 24.06.1994 DE 4422113
(43) Veröffentlichungstag der Anmeldung: 27.12.1995
(73) Patentinhaber: WABCO GmbH, 30453 Hannover (DE)
(72) Erfinder: Lehrmann, Joachim, D-31275 Lehrte (DE); Gudat, Wolfgang, D-30926 Seelze (DE)
(74) Vertreter: Günther, Constantin

(56) Entgegenhaltungen:
- EP-A- 0 098 587
- DE-A- 4 121 545
- DE-A1- 3 310 477
- DE-A1- 3 841 893
- DE-C2- 3 833 146

## Beschreibung

Die Erfindung betrifft ein Elektronikmodul gemäß dem Oberbegriff des Patentanspruchs 1. Ein solches Elektronikmodul ist aus DE 384 1893 A1 bekannt.

Ein derartiges Elektronikmodul ist durch die ABS/ASR-C-Elektronik von WABCO Westinghouse Fahrzeugbremsen bekannt. Bei dem vorbekannten Gerät tritt jedoch das Problem auf, daß zu seiner Fertigung mehrere Verfahrensschritte erforderlich sind. In einem ersten Verfahrensschritt wird die Leiterplatte mit Bauelementen und dem Kühlelement bestückt. Hierauf erfolgt ein zweiter Verfahrensschritt, in dem die bestückte Platine im Lötbad gelötet wird. In einem dritten Verfahrensschritt wird der Deckel an der Leiterplatte befestigt und die wärmeleitende Verbindung zwischen Kühlelement und Deckel hergestellt.

Der Erfindung liegt deshalb die Aufgabe zugrunde, ein Elektronikmodul der eingangs genannten Art so weiterzubilden, daß die Herstellung vereinfacht und verbilligt wird.

Diese Aufgabe wird durch die im Patentanspruch 1 wiedergegebene Erfindung gelöst. Weiterbildungen und vorteilhafte Ausführungsformen der Erfindung sind in den Unteransprüchen angegeben.

Ein Vorteil der Erfindung besteht darin, daß der Deckel vor dem Lötvorgang zusammen mit anderen Bauteilen an der Leiterplatte befestigt werden kann. Dies führt dazu, daß ein gesonderter Montageschritt für das Befestigen des Deckels an der Leiterplatte nach dem Lötbad entfällt.

Gemäß einer vorteilhaften Weiterbildung der Erfindung wird bei einer Leiterplatte, bei der wenigstens eines der Bauteile als wärmeerzeugendes Leistungsbauteil ausgebildet ist und die ein Kühlelement zur Kühlung des Leistungsbauteils trägt, das Kühlelement mit dem Deckel einstückig ausgebildet. Diese Weiterbildung der Erfindung weist den Vorteil auf, daß die Wärmeleitung zwischen dem wärmeerzeugenden Leistungsbauteil einerseits und dem Kühlelement andererseits und schließlich dem wärmeabgebenden Deckel erheblich verbessert ist. Wenn dagegen das Kühlelement und der Deckel als gesonderte Bauteile ausgebildet sind, kommt es nämlich bei der Befestigung des Kühlelements am Deckel zu nicht zu verhindernden minimalen Luftspalten, die hohe Wärmeübergangswiderstände darstellen und die Wärmeableitung zwischen Kühlrahmen und Deckel erheblich beeinträchtigen.

Gemäß der Erfindung weist der Deckel Aussparungen zur Aufnahme wenigstens eines Anschlußsteckers auf. Der Anschlußstecker ist deckelaußenseitig anschlußfähig und deckelinnenseitig mit den Leiterbahnen der Leiterplatte verbunden. Der Vorteil der Erfindung besteht darin, daß beim Löten der Anschlußstecker bereits ohne zusätzliche Hilfsmittel in seiner Endstellung durch den Deckel gehalten wird.

Gemäß einer weiteren Weiterbildung der Erfindung sind der Deckel, die Leiterplatte und der im Deckel aufgenommene Anschlußstecker mittels wenigstens eines alle diese Teile durchdringenden Verbindungselementes miteinander verbunden. Diese Weiterbildung der Erfindung weist den Vorteil auf, daß durch die platzsparende Montage auf der bestückten Seitenfläche der Leiterplatte Platz für weitere Bestückungen mit Bauteilen zum Zwecke von Schaltungserweiterungen bei gleichbleibender Platinengröße verfügbar wird. Bei gleichbleibendem Schaltungsbedarf kann die Platine unter Umständen verkleinert werden.

Die Erfindung sowie die beschriebenen Weiterbildungen der Erfindung lassen sich besonders vorteilhaft auch in Kraftfahrzeugen verwenden. Dies insbesondere deshalb, da in Kraftfahrzeugen die räumlichen Verhältnisse für Elektronikmodule beengt sind und in diesen beengten Verhältnissen eine vergleichsweise hohe Verlustleistung der Leistungsbauteile abgeführt werden muß.

Die Erfindung wird anhand eines Ausführungsbeispiels unter Zuhilfenahme von Zeichnungen näher erläutert.

Es zeigen
- Fig. 1: ein erfindungsgemäßes Elektronikmodul in Seitenansicht mit Teilschnitt
- Fig. 2: das Elektronikmodul nach Fig. 1 in der Draufsicht mit Teilschnitt und
- Fig. 3: die Perspektivansicht des Elektronikmoduls nach Fig. 1.

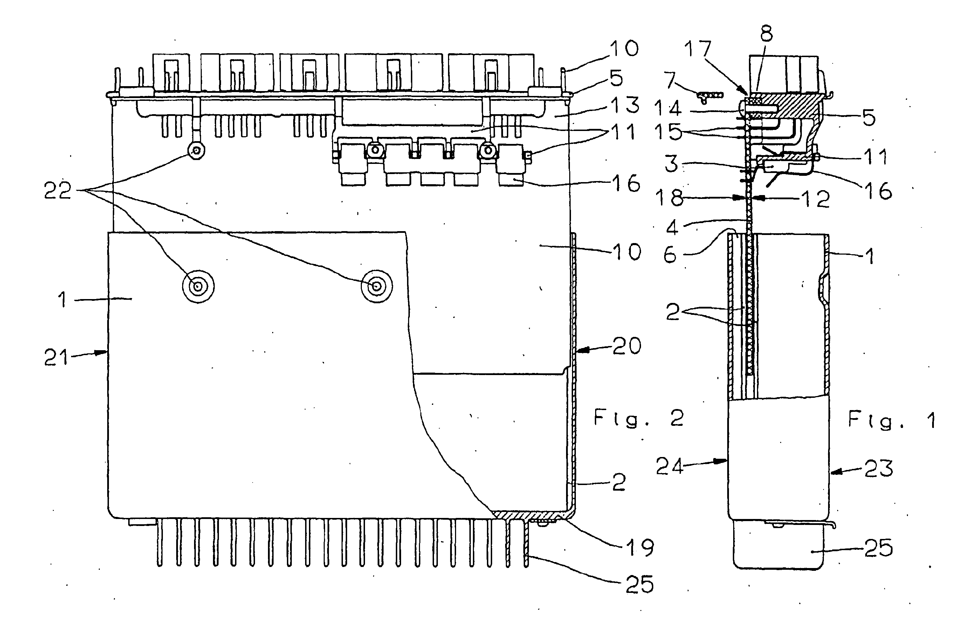

In den Fig. 1, 2 und 3 werden gleiche Bezugszeichen für einander entsprechende Teile verwendet.

Das erfindungsgemäße Elektronikmodul gemäß Fig. 1 zeigt in Seitenansicht einen Gehäusetopf (1) mit innenliegenden Schubführungs- und Halteelementen (2), eine mit mindestens einem sich relativ stark erwärmenden Leistungsbauteil (3) bestückte Leiterplatte (4) und einen Deckel (5).

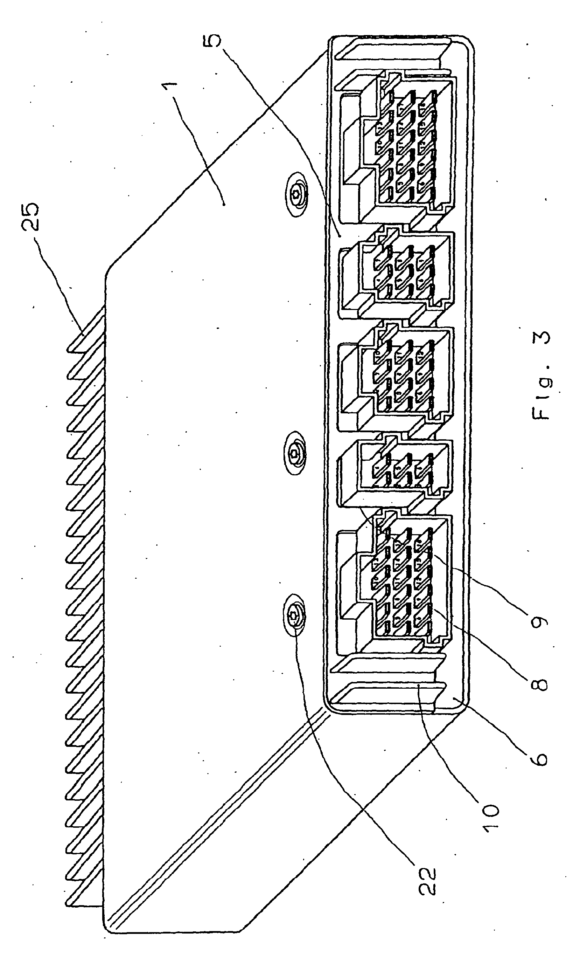

Der Gehäusetopf (1) ist als einseitig offen gestalteter, quaderförmiger Hohlkörper aus wärmeleitendem Material, insbesondere Metall, ausgebildet. Der Deckel (5) ist als Kühlkörper mit in Fig. 3 dargestellten Aussparungen (9), die zur Leiterplatte (4) gerichtet einseitig offen sind, ausgebildet, in den in Fig. 3 dargestellte Anschlußstecker (8) einpaßbar sind. Die Anschlußstecker (8) sind am Deckel (5) befestigbar.

Der Deckel (5) besitzt in Fig. 2 dargestellte deckelaußenseitig und deckelinnenseitig angeformte Kühlelemente (10) und (11) aus wärmeleitenden Materialien. Der Deckel (5) mit den eingepaßten Anschlußsteckern (8) ist auf eine Bauelemente tragende Seitenfläche (12) der Leiterplatte (4) am in Fig. 2 dargestellten deckelseitigen Randabschnitt (13) aufgesetzt und befestigt. Die Befestigung kann in der Form erfolgen, daß der Deckel (5), die eingepaßten Anschlußstecker (8) und die mit Leistungsbauteilen (3) bestückte Leiterplatte (4) mittels einer oder mehreren Schrauben (14) verbunden wird, wobei eine Schraube alle genannten Teile durchdringt. Das heißt, der Deckel (5), die Anschlußstecker (8) und die Leiterplatte (4) werden mit denselben Schrauben (14) durchgehend verbunden. Der Deckel (5) weist dabei einen parallel zur Leiterplatte (4) verlaufenden Vorsprung auf, der von der Schraube (14) durchdrungen wird. Diese Verschraubung der genannten Teile zu einer Baueinheit (3, 4, 5, 8, 14) bringt Montagevorteile.

Anstelle von Schrauben zur Verbindung des Deckels (5), der Anschlußstecker (8) und der Leiterplatte (4) können auch andere Verbindungselemente benutzt werden, die die genannten Teile durchdringen. Als Beispiele seien hier einpreßbare Stifte wie z. B. Kerbstifte oder stiftartige Federelemente wie Spannhülsen oder Spiralspannstifte genannt. Bei Verwendung von stiftartigen Verbindungselementen können der Deckel (5), die Anschlußstecker (8) und die Leiterplatte (4) mit ihrer vollständigen Bestückung mit Hilfe des stiftartigen Verbindungselementes zu einer Baueinheit (3, 4, 5, 8, 14) verbunden werden und die Baueinheit (3, 4, 5, 8, 14) kann dann über das Lötbad geführt werden. Durch diesen Lötprozeß können dann vorteilhaft alle elektronischen Bauteile einerseits und das wenigstens an seinem leiterplattenseitigen Ende lötbare stiftartige Verbindungselement andererseits durch Lötung fest mit der lötbadfähigen Seitenfläche (18) der Platine (4) verbunden werden. Eine besondere Abwandlung von stiftartigen Verbindungselementen kann darin bestehen, am Deckel (5) auf der der Leiterplatte zugewandten Seite einteilig mit dem Deckel einen Stift als Zapfen anzuformen. Dieser Zapfenstift dient dann zur Verbindung des Deckels des Anschlußsteckers (8) und der Leiterplatte (4) zu einer Baueinheit (3, 4, 5, 8, 14), welche dann wie vorstehend beschrieben, im Lötbad durch Lötung mit der Platine (4) verbunden werden kann. Bei dem in der Zeichnung dargestellten Ausführungsbeispiel sind die Anschlußstecker (8) deckelaußenseitig anschlußfähig und deckelinnenseitig über Kontaktanschlüsse (15) an Leiterbahnen der Leiterplatte (4) angeschlossen.

Die in unmittelbarer Nähe der deckelinnenseitig angeformten Kühlelemente (11) des Deckels (5) angeordneten zu kühlenden Leistungsbauteile (3) schmiegen sich an die Kühlelemente (11) an. Eine enge Kontaktierung zwischen den Berührungsflächen eines Kühlelementes (11) und eines Leistungsbauteils (3) kann durch die Spannkraft einer Klammer (16), die beide Elemente (3) und (11) umfaßt, verbessert werden, was die Wärmeableitung von den Leistungsbauteilen (3) fördert.

Durch die Gestaltung des Deckels (5) mit deckelaußenseitig und deckelinnenseitig angeformten Kühlelementen (10) und (11) als einen einheitlichen Kühlkörper wird ein Abbau des Wärmestaus aus dem Bereich der Leistungsbauteile (3) und eine Verbesserung der Wärmeableitung in die parallel zur Leiterplatte gerichtete Umgebung des Elektronikmoduls erreicht.

Durch die kontaktierende Anordnung der Leistungsbauteile (3) an die Kühlelemente (11) wird Platz auf der Platine eingespart und die übrige Fläche der Leiterplatte (4) ist frei für die Bestückung mit anderen Bauelementen. Die Vorteile dieser Platzeinsparung sind dieselben, wie sie bei der Beschreibung der Befestigung mit Hilfe der alle Teile durchdringenden Schraube (14) bereits erläutert wurden.

Als sich relativ stark erwärmende Leistungsbauteile (3) werden all die Bauelemente bezeichnet, in denen bei Stromdurchgang eine hohe Verlustwärme erzeugt wird, die bei hoher Packungsdichte der Bauelemente auf der Leiterplatte (4) zu einem Wärmestau und in dessen Folge sogar zum Fehlverhalten bzw. zur Zerstörung dieser Bauelemente oder anderer in unmittelbarer Umgebung befindlicher Bauelemente führen kann. Die Leistungsbauteile (3) sind meistens Transistoren, aber auch Widerstände und Spannungsregler sowie andere Bauelemente können bei Stromdurchgang eine hohe Verlustwärme erzeugen. Auch Mikroprozessoren, die nicht direkt mittels Kontakt gekühlt werden können, erzeugen Verlustwärme und tragen zum Wärmestau bei.

Die am deckelseitigen Randabschnitt (13) an der Stirnkante (17) der Leiterplatte (4) durchgeführte Aufsatzbefestigung des Deckels (5) auf die Leistungsbauteile tragende Seitenfläche (12) der Leiterplatte (4) ohne Überhang des Deckels (5) hin zur gegenüberliegenden lötbadfähigen Seitenfläche (18) der Leiterplatte (4) gestattet es, die Baueinheit (3, 4, 5, 8, 14) in vorteilhafter Weise über ein Wellenlötbad zu führen. Vorher werden die Leistungsbauteile bereits in ihrer endgültigen Lage auf der Leiterplatte fixiert. Vorteilhafterweise kann für diesen Lötprozeß auf eine zusätzliche Hilfshalterung zur Vorfixierung der Leistungsbauteile verzichtet werden. Es entfallen auch die für die Hilfshalterungen erforderlichen Montageschritte. Außerdem ist es vor allem möglich, die Leistungsbauteile mechanisch spannungsfrei zu fixieren. Die Klammer (16) verbessert die Fixierung, indem sie bewirkt, daß die Leistungsbauteile (3) flächig und ohne Luftspalt am deckelinnenseitigen Kühlelement (11) anliegen.

Der Gehäusetopf (1) enthält innenwandig an den in Fig. 2 dargestellten schmalflächigen Seitenwänden (20) und (21) Schubführungs- und Halteelemente (2), die z. B. in Form von Führungsrinnen ausgestaltet sein können. Zusätzlich ist eine Arretierbarkeit mittels der in Fig. 3 dargestellten Schraubverbindungen (22) zwischen mindestens einer der beiden breitflächigen Seitenwände (23, 24) des Gehäusetopfes (1) und dem Deckel (5) vorgesehen, durch deren flächige Anlage eine zusätzliche Kontaktierung erreicht wird, sowie eine verbesserte Ableitung des Wärmestaus ausgehend von den deckelinnenseitig angeformten Kühlelementen (11) über den Gehäusetopf (1) in die Umgebung gestattet wird.

Durch die konstruktive Gestaltung des Deckels (5) ohne Überhang verbleibt eine Öffnung (6) zwischen der lötfähigen Seitenfläche (18) der Leiterplatte (4) und der breitflächigen Seitenwand (23), die entweder offen bleiben oder durch eine einfache Hilfsabdeckung (7) abgedeckt werden kann. Diese zusätzliche Hilfsabdeckung muß nicht aus wärmeleitendem Material bestehen und muß auch keine weiteren Funktionen wie Festhalten (Fixieren etc.) erfüllen. Die Hilfsabdeckung kann als eine einfache Blende ausgeführt sein und nach der Montage der Baueinheit (3, 4, 5, 8, 14) mit dem Gehäusetopf (1) auf die Öffnung (6) aufgesteckt werden.

Die Bestückung der Leiterplatte (4) mit weiteren Bauelementen zur Verwirklichung des vorgegebenen Elektronikkonzepts kann möglicherweise zu einer hohen Packungsdichte führen. Damit können Wärmestauprobleme entstehen, die eine Einbeziehung weiterer Kühlmöglichkeiten am Elektronikmodul erforderlich machen.

Gemäß Fig. 2 sind bei Erfordernis von weiteren Kühlmöglichkeiten zusätzliche Kühlelemente (25) vorhanden, die am Gehäusetopf (1) außerhalb der Bodenwand (19) des Gehäusetopfes (1) angeformt sind. Die als Kühlrippen ausgebildeten Kühlelemente (25) unterstützen in vorteilhafter Weise den Abbau des Wärmestaus im Gehäusetopf besonders dann, wenn mehrere Elektronikmodule im Fahrzeug dicht aneinander gepackt angeordnet sind, und zwischen ihnen bzw. an ihren breitflächigen Seitenwänden keine Konvektion möglich ist.

Andererseits gibt es auch Anwendungsfälle, bei denen die Wärmeleitung über den Deckel (5) ausreicht. In diesen Fällen kann der Gehäusetopf (1) aus einem einfachen, nicht wärmeleitenden Material (z. B. Kunststoff) bestehen und er muß auch keine Kühlelemente (25) mehr aufweisen.

In bekannter Weise kann der Deckel (5) im Druckgußverfahren als Druckgußteil hergestellt werden.

### Bezugszeichenliste

- 1: Gehäusetopf
- 2: Schubführungs- und Halteelement
- 3: Leistungsbauteil
- 4: Leiterplatte
- 5: Deckel
- 6: Öffnung
- 7: Hilfsabdeckung
- 8: Anschlußstecker
- 9: Aussparung
- 10: Kühlelement, deckelaußenseitig
- 11: Kühlelement, deckelinnenseitig
- 12: bestückte Seitenfläche
- 13: deckelseitiger Randabschnitt
- 14: Schraube
- 15: Kontaktanschluß
- 16: Klammer
- 17: Stirnkante
- 18: lötbadfähige Seitenfläche
- 19: Bodenwand
- 20: schmalflächige Seitenwand
- 21: schmalflächige Seitenwand
- 22: Schraubverbindung
- 23: breitflächige Seitenwand
- 24: breitflächige Seitenwand
- 25: Kühlelement, bodenwandaußenseitig

## Patentansprüche

1. Elektronikmodul mit einem Gehäusetopf (1) zur Aufnahme mindestens einer mit Bauteilen bestückten Leiterplatte (4) und einem Deckel (5), mit folgenden Merkmalen:
a) der Gehäusetopf (1) ist als einseitig offen gestalteter, quaderförmiger Hohlkörper ausgebildet,
b) der Deckel (5) ist mit der Leiterplatte (4) an deren deckelseitigem Randabschnitt (13) verbunden,
c) der Deckel (5) weist Aussparungen (9) zur Aufnahme wenigstens eines Anschlußsteckers (8) auf
**dadurch gekennzeichnet,**
**daß** der Deckel (5) nicht über die Lötseite (18) der Leiterplatte (4) hinausragt.

2. Elektronikmodul nach Patentanspruch 1 für eine Leiterplatte (4), bei der wenigstens eines der Bauteile als wärmeerzeugendes Leistungsbauteil (3) ausgebildet ist und die ein Kühlelement (10, 11) zur Kühlung des Leistungsbauteils (3) trägt,
**dadurch gekennzeichnet,**
**daß** das Kühlelement (10, 11) einstückig mit dem Deckel (5) ausgebildet ist.

3. Elektronikmodul nach Patentanspruch 1 oder 2,
**dadurch gekennzeichnet,**
**daß** der Deckel (5), die Leiterplatte (4) und der im Deckel (5) aufgenommene Anschlußstecker (8) mindestens mittels wenigstens eines alle genannten Teile durchdringenden Verbindungselementes (14) verbunden sind.

4. Elektronikmodul nach wenigstens einem der vorhergehenden Patentansprüche,
**dadurch gekennzeichnet, daß**
der Deckel (5) als ein Druckgußteil ausgebildet ist.

## Claims

1. Electronic module having a pot-shaped housing part (1) for accommodating at least one circuit board (4) equipped with components, and having a cover (5), having the following features:
a) the pot-shaped housing part (1) is in the form of a parallelepipedal hollow body which is open on one face,
b) the cover (5) is joined to the circuit board (4) at the cover-end edge region (13) of the circuit board (4),
c) the cover (5) has openings (9) for accommodating at least one connecting plug (8),
**characterised in that**
the cover (5) does not project out beyond the solder side (18) of the circuit board (4).

2. Electronic module according to patent claim 1, for a circuit board (4) wherein at least one of the components is in the form of a heat-producing power component (3) and which carries a cooling element (10, 11) for cooling the power component (3),
**characterised in that**
the cooling element (10, 11) is of integral construction with the cover (5).

3. Electronic module according to patent claim 1 or 2,
**characterised in that**
the cover (5), the circuit board (4), and the connecting plug (8) accommodated in the cover (5) are joined at least by means of at least one joining element (14) passing through all the mentioned parts.

4. Electronic module according to at least one of the preceding patent claims,
**characterised in that**
the cover (5) is in the form of a die-cast part.

## Revendications

1. Module électronique équipé d'un boîtier (1) pour recevoir au moins une plaquette de circuit imprimé (4) équipée de composants et d'un couvercle (5), avec les caractéristiques suivantes :
a) le boîtier (1) est réalisé sous la forme d'un corps creux parallélépipédique ouvert d'un côté,
b) le couvercle (5) est relié à la plaquette de circuit imprimé (4) sur un bord côté couvercle (13) de celle-ci,
c) le couvercle (5) présente des évidements (9) pour recevoir au moins une fiche de raccordement (8),
**caractérisé en ce que** le couvercle (5) ne déborde pas du côté soudure (18) de la plaquette de circuit imprimé (4).

2. Module électronique selon la revendication 1 pour une plaquette de circuit imprimé (4), dans lequel au moins un des composants est réalisé sous la forme d'un composant de puissance (3) générant de la chaleur et qui supporte un élément de refroidissement (10, 11) pour refroidir le composant de puissance (3), **caractérisé en ce que** l'élément de refroidissement (10, 11) est réalisé d'une seule pièce avec le couvercle (5).

3. Module électronique selon la revendication 1 ou 2, **caractérisé en ce que** le couvercle (5), la plaquette de circuit imprimé (4) et la fiche de raccordement (8) logée dans le couvercle (5) sont reliés au moins par l'intermédiaire d'au moins un élément de liaison (14) pénétrant dans toutes les parties précitées.

4. Module électronique selon l'une quelconque des revendications précédentes, **caractérisé en ce que** le couvercle (5) est réalisé sous la forme d'une pièce coulée sous pression.
